# EUROPEAN PATENT SPECIFICATION

(11) **EP 0 509 697 B1**
(45) Date of publication and mention of the grant of the patent: **09.06.1999**
(21) Application number: 92303038.1
(22) Date of filing: 07.04.1992
(51) Int. Cl.: H01L 27/115, H01L 21/8247

(54) **Stacked etch fabrication of cross-point EPROM arrays**
Gestapeltes Ätzverfahren für Koppelpunkt-EPROM-Matrizen
Fabrication par gravure empilée des matrices EPROM du type à points de croisement

(30) Priority: 18.04.1991 US 687105
(43) Date of publication of application: 21.10.1992
(73) Proprietor: NATIONAL SEMICONDUCTOR CORPORATION, Santa Clara, California 95052 (US)
(72) Inventor: Bergemont, Albert M., San Jose, California 95129 (US)
(74) Representative: Horton, Andrew Robert Grant

(56) References cited:
- EP-A- 0 396 508
- US-A- 4 460 981
- US-A- 4 613 956

## Description

The present invention relates to electrically programmable read-only memory (EPROM) devices and, in particular, to a process for fabricating a stacked etch, contactless EPROM array that utilizes cross-point cells and internal access transistors.

An electrically programmable read-only memory (EPROM) device as a non-volatile memory integrated circuit which is used to store binary data. Power can be removed from an EPROM without loss of data. That is, upon reapplying power, the originally stored binary data is retained.

In addition to its data retention capability, an EPROM can also be programmed to store new binary data. Reprogramming is accomplished by first exposing the EPROM to an ultra-violet (UV) light source in order to erase the old binary data. A UV-transparent lid on the packaged EPROM chip allows this erasure to occur. Following erasure, the new binary data is written to the EPROM by deactivating the chip select line in order to switch the EPROM data outputs to inputs. The EPROM address inputs are then set to a starting value, the desired data is connected to the data inputs and the data is written into the data storage register identified by the address inputs. The address inputs are then incremented and the cycle is repeated for each data storage register in the EPROM array.

In an EPROM read operation, the binary data stored in the data storage register identified at the address inputs is connected to the EPROM's data output buffers. If the EPROM chip select signal is activated, then the binary data from the selected storage register is provided to the databus.

Traditionally, reductions in EPROM memory density have been accomplished by reducing the dimensions of the cell features produced by the photolithographic and etching procedures utilized in fabricating standard T-shaped EPROM cells. The shrinking cell geometries resulting from these process developments have led to corresponding requirements for new isolation schemes in order to accommodate the minimum cell pitch and to develop the sub-micron contacts which must be formed utilizing non-standard techniques.

For example, Hisamune et al, "A 3.6nm² Memory Cell Structure for 16mb EPROMs, IEDM 1989, pg. 583, disclose a process for minimizing EPROM cell pitch utilizing trench isolation of the bit lines and tungsten plugs for bit line contacts. Bergemont et al, "A High Performance CMOS Process for Sub-micron 16 mv EPROM", IEDM 1989, page 591, also disclosed techniques for reducing the size of the standard T-shaped EPROM cell.

One way to avoid the special processing requirements associated with the fabrication of high density T-shaped EPROM cell arrays is to use a different type of cell which does not require the use of field oxide isolation and contacts in the array.

EP-0461764-A2 published on 18th December 1991 discloses a contactless EPROM cell array and its associated process flow. The contactless concept disclosed in the Eitan application is very attractive because it allows high density EPROMs to be fabricated without using aggressive technologies and design rules. The basic idea of the Eitan disclosure is the use of a "cross-point" EPROM cell, i.e. a cell which is defined by the crossing of perpendicular polysilicon 1 and polysilicon 2 lines in a virtual ground array. In order to avoid drain turn on, i.e. leaky non-selected cells on the same bit line during programming, and true virtual source decoding, metal contacts silicon every two bit lines and the non-contacted bit lines are connected to the Vss or Vcc lines via an access transistor.

However, there are several problems and disadvantages associated with the Eitan process flow. First, five layers of processing are required over the polysilicon 1 layer; oxide/nitride/oxide/polysilicon cap nitride. The polysilicon 1 and the five overlying layers are defined twice, once at polysilicon 1 mask and once at polysilicon 1 island mask. These two etching steps are very critical because they define, respectively, the length and width of the EPROM cell. Etching more layers in this way presents more difficulties in critical dimension control. Also, failing to remove any one of the five layers presents the risk of polysilicon 1 stringers along the edges of the field oxide. These edges are located in the neighbourhood of the access transistors, as well throughout the array.

Because the polysilicon 2 is not self-aligned with the polysilicon 1, a special "array field implant" is required in order to avoid leakages between adjacent bit lines. These leakages occur when polysilicon 2 is misaligned with polysilicon 1. The polysilicon 2 controls one part of the silicon and leads to a parasitic polysilicon 2 transistor between adjacent bit lines. For this reason, a high threshold voltage is required to avoid the turn on of this parasitic polysilicon 2 transistor. This is done using an array boron field implant.

In addition to the implant, the process described in EP-0461764-A2 calls for an "isolation oxide" to move the field threshold to a sufficiently high voltage. This field implant leads to boron lateral diffusion into the channel of the cell, leading to channel width reduction, high bit line loading and reduction of the bit line to substrate breakdown voltage.

Additionally, the polysilicon etch is very critical in the process. The polysilicon 2 etching terminates on a polysilicon cap. In order to maintain the coupling ratio, it is necessary to stop the etch within a nominal polysilicon cap thickness. This is difficult from the point of view of overetched latitude with a thin polysilicon cap layer. Depending on the thickness of the isolation oxide, polysilicon 1 to polysilicon 2 misalignment will affect the parasitic capacitance of the word lines.

Furthermore, removing the top nitride before polysilicon 2 deposit may affect the quality of the oxides all around the polysilicon 1 floating gate. This could affect program disturb and data retention.

European patent specification EP-0396508 discloses a fabrication procedure for an EPROM cell array in which the control gate is etched in a longitudinal sense with the floating gate, a further layer of polysilicon is deposited in contact with the etched control gate and etched, along with the floating gate, to define the transverse direction.

### Summary of the Invention

The present invention uses a stacked etch, i.e. edges of the polysilicon floating gate parallel to the polysilicon word line are self-aligned to the word line. This eliminates the parasitic polysilicon transistor and all steps required to cope with the problems associated with it (namely, special boron array field implant and isolation oxide). Furthermore, the process of the present invention does not use a polysilicon cap and nitride layer.

According to the present invention there is provided a method of fabricating a cross-point EPROM array in a silicon substrate of P-type conductivity, the array including a cell array area and a peripheral area, the method comprising:
(a) forming a layer of first insulating material on the silicon substrate;
(b) forming a first layer of polysilicon from which a floating gate is to be fabricated on the layer of insulating material;
(c) forming a layer of second insulating material on the first layer of polysilicon;
(d) forming a first mask to define parallel lines on the second insulating material and underlying first layer of polysilicon;
(e) etching exposed portions of the second insulating material and underlying first layer of polysilicon to define parallel vertical strips of second insulating material and first layers of polysilicon, this etching step being prior to deposit of a second polysilicon layer from which word lines are to be fabricated;
(f) after removing the first mask, forming N+ regions in the silicon substrate between the parallel vertical strips of second insulating material and first layer of polysilicon;
(g) performing a differential oxidation step to form additional oxide on the second insulating material of the vertical strips while simultaneously forming oxide over the N+ regions;
(h) forming a second mask for protecting the cell array area;
(i) removing the second insulating material, and underlying first layer of polysilicon and first insulating material from the peripheral area;
(j) after removing the second mask, forming gate oxide regions in the peripheral area;
(k) forming the second layer of polysilicon from which word lines are to be fabricated over the structure formed in steps (a)-(j) above;
(l) forming a layer of conductive material over the second layer of polysilicon;
(m) forming a third mask on the layer of conductive material to define parallel lines of the second layer of polysilicon that run perpendicular to the strips of the first polysilicon layer;
(n) etching the conductive material and the underlying second layer of polysilicon to define polysilicon word lines running perpendicular to the strips of the first layer of polysilicon but separated therefrom by the second insulating material;
(o) forming a self aligned etch mask over the third mask in the peripheral area; and
(p) utilizing the polysilicon word lines in a stacked etch step to define the floating gates in the first layer of polysilicon at the cross-point EPROM cells of the array.

### Description of the Drawings

Figure 1 is a cross-sectional view illustrating a conventional stacked etch EPROM cell.

Figure 1B is a plan view illustrating the layout of a conventional T-shaped stacked etch EPROM cell.

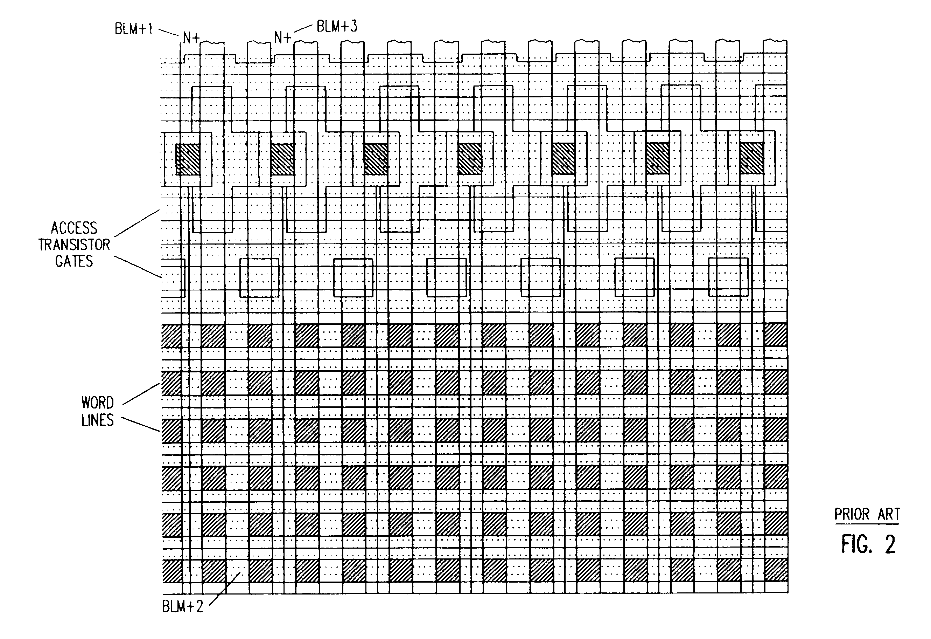

Figure 2 is a layout illustrating a portion of a prior art contactless EPROM cell array.

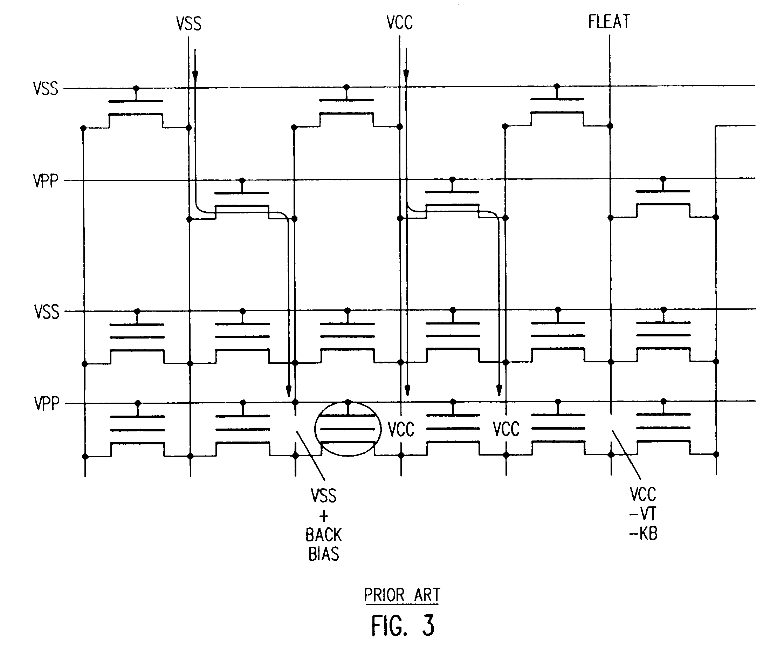

Figure 3 is a schematic diagram illustrating an equivalent circuit for the Figure 2 layout.

Figures 4-7 illustrate sequentially a first EPROM array fabrication process flow in accordance with the present invention.

Figures 8-12 illustrate sequentially a second EPROM array fabrication process in accordance with the present invention.

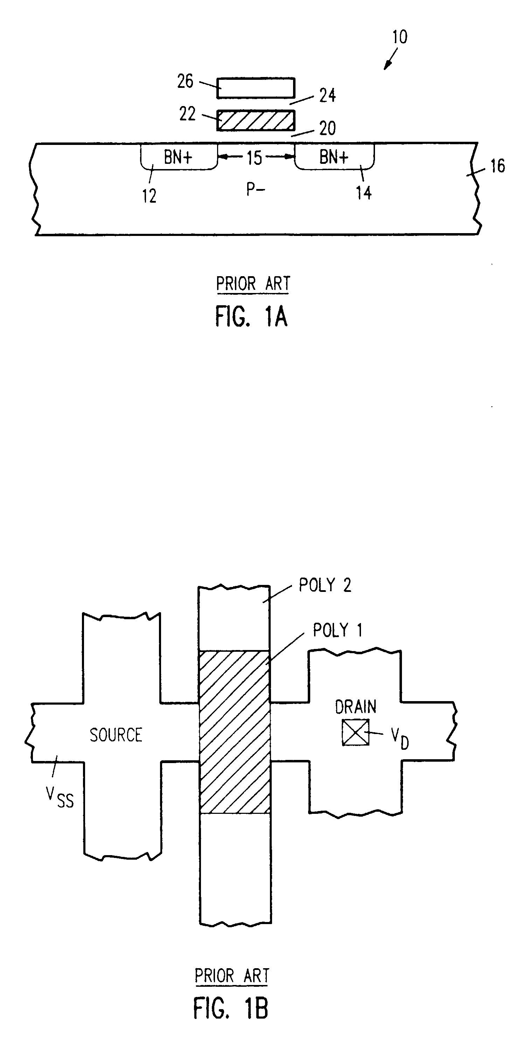

Figure 1A shows a conventional EPROM cell 10. EPROM cell 10 includes a buried N+ source region 12 and a buried N+ drain region 14 formed in a P-type silicon substrate 16 and separated by a substrate channel region 18. Overlying channel region 18 is a layer of insulating material 20, typically silicon dioxide. A polysilicon (polysilicon 1) floating gate 22 is formed on the insulating material 20. Overlying floating gate 22 is a second layer 24 of insulating material, usually a composite layer of oxide-nitride-oxide (ONO). A polysilicon (polysilicon 2) control gate 26 is formed on the ONO layer 24.

A plan view of this so-called "stacked gate" (or "stacked etch") EPROM cell 10 is shown in Figure 1B. The structure of the standard "T-shaped" cell 10 shown in Figure 1B derives its "stacked-gate" designation because of the self-aligned etching process which utilizes the vertical alignment of the polysilicon 2 control gate 26 with the polysilicon 1 floating gate 22 to complete the definition of the floating gate 22.

The processing sequence for defining the polysilicon 1 floating gate 22 and the polysilicon 2 control gate line 26 of the stacked gate cell 10 is as follows. Referring to Figure 1A first, a layer of polysilicon (polysilicon 1) is formed on the silicon dioxide layer 20. The polysilicon 1 layer is then masked and etched to form polysilicon 1 strips. The edges of the polysilicon strips are then utilized in a self-aligned arsenic implant step to form the buried N+ source and drain regions 12 and 14, respectively. Next, an oxide-nitride-oxide (ONO) layer 24 is formed over the entire structure. This is followed by formation of a second polysilicon layer (polysilicon 2) which is masked and etched to form the control gate line 26. The resulting polysilicon 2 control gate line 26 is then used as a self-aligned mask to etch the interpoly ONO 24 and the underlying polysilicon 1 floating gate 22 to define the final structure of the stacked gate cell 10 shown in Figure 1A.

A process methodology will now be described for the stacked etch fabrication of an EPROM array that utilizes cross-point cells with an internal access transistor. The process flow will be presented in two parts. The first part describes a flow wherein the gate oxide of the access transistors is the same physical oxide as the oxide used in the array periphery, i.e. out of the cell array. This flow will be referred to hereinbelow as Scenario 1. The second flow, which will be referred to hereinbelow as Scenario 2, utilizes an access transistor gate oxide that is identical to the floating gate oxide.

As will be described below, both Scenario 1 and Scenario 2 have advantages and disadvantages when compared to one another. The object of the following discussion is not to assess which of Scenarios 1 and 2 is preferred, but to provide an extended stacked etch process flow for a cross-point of cell layout.

Each of Scenarios 1 and 2 is presented below at sequential steps of the corresponding cell process flow with cross-sectional drawings. Each figure includes a plan view of the structure at that stage of the process flow and the following three cross-sectional views in the structure: (1) in the word line direction in the EPROM cell array (designated "A/A"), (2) in the polysilicon 1 direction perpendicular to the word line in both the EPROM cell and the access transistor array (designated "B/B"), and (3) in the word line direction in the access transistor area (designated "C/C").

### Scenario 1

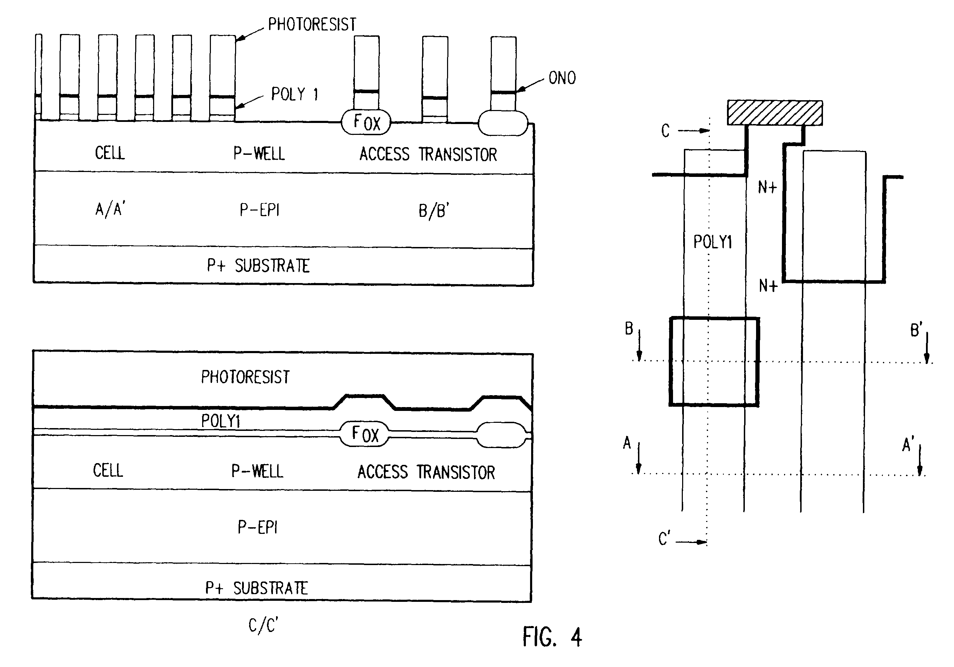

The process flow for Scenario 1 will be described in conjunction with Figures 4-7.

The Scenario 1 process flow begins with conventional steps. First a 200 Angstroms (10 Angstroms = 1 nm) floating gate oxide is formed on a P-type silicon substrate. Next a layer of polysilicon (polysilicon 1) is deposited to a thickness of about 1500 Angstroms and doped with phosphorus at a dose of 2-5x10¹⁵ at low implant energy.

Next, as can be seen from Figure 4, only three layers are formed on top of the polysilicon 1; oxide/nitride/oxide, commonly called ONO. After growing these three layers, a photoresist mask is used to define vertical strips of polysilicon 1 which are then plasma etched to form parallel vertical lines of ONO/polysilicon 1.

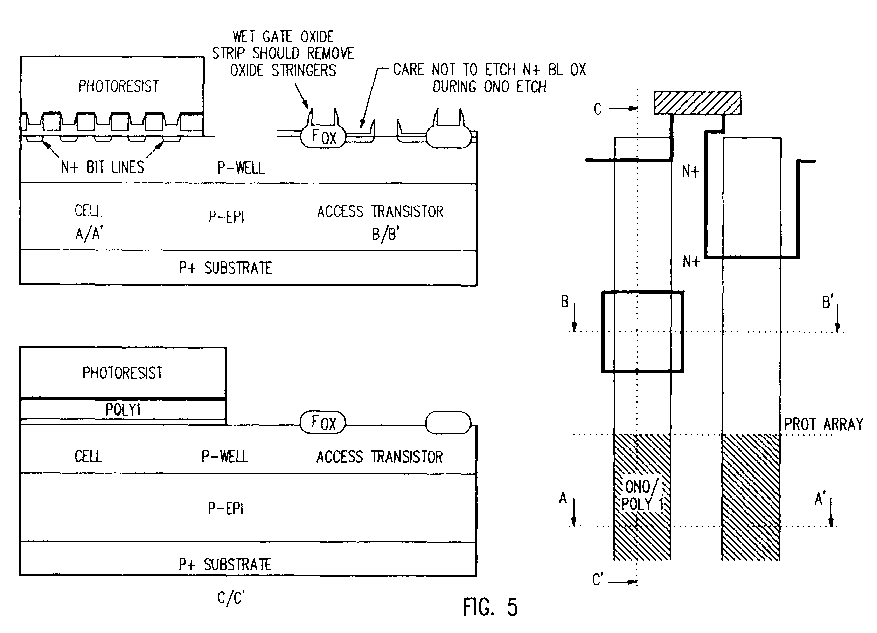

Referring to Figure 5, after stripping the photoresist from the polysilicon 1 mask, a thin edge oxide is grown between the polysilicon 1 lines. The polysilicon 1 lines are then used in a self-aligned to arsenic implant to define the N+ bit lines. Next, a "differential" oxide is grown over the N+ bit line areas to give substantial latitude to the further ONO and/or polysilicon plasma etched steps. If, for example, a polysilicon plasma etch is performed without formation of the differential oxide, then this step may lead to the digging of silicon in the exposed N+ bit line areas. For this reason, the differential oxide contributes to the equivalent oxide loss during ONO etch and is, hence, called differential oxide.

Next, a mask step called a protect array is performed. This mask has two goals: first, to etch away, out of the array, the ONO/polysilicon layer (the polysilicon 1 mask is a dark field mask) leaving ONO/polysilicon 1 out of the array. This avoids the use of an extra mask to protect the periphery at the N+ bit line arsenic implant. In the flow of Scenario 1 process, the arsenic implant is performed on the full wafer with no mask. Second, it removes the ONO/polysilicon 1 vertical lines in the regions of the access transistors.

Next, the ONO/polysilicon 1 layers are plasma etched and the underlying floating gate oxide is etched off in wet chemistry utilizing diluted HF. Then, the photoresist is stripped.

In Figure 5, the layout presents the different layers at the end. As illustrated, no more ONO/polysilicon 1 is present on the upper side of the protect mask. On the lower side of the protect mask, ONO/polysilicon 1 vertical lines are still present to further provide the floating gates of the EPROM cells.

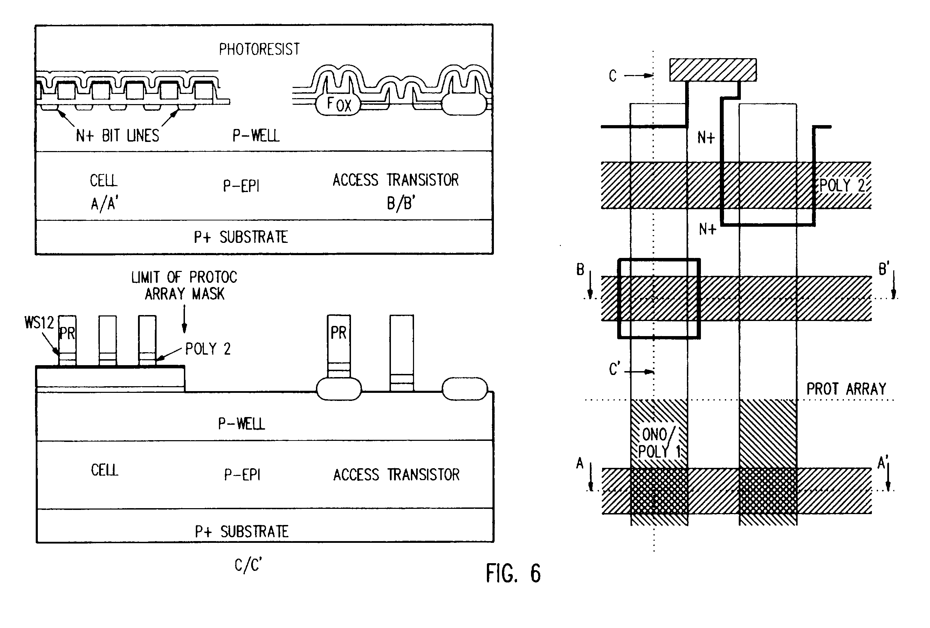

Referring now to Figure 6, the next step in the Scenario 1 process involves the growth of 200 Angstroms gate oxide 2 in regions of the access transistor gates and everywhere in the gate channel regions out of the array. A threshold voltage mask (VTP mask) is then performed and P channel regions are boron implanted to provide the right threshold voltage. After VTP mask photoresist strip, a second layer of 2000 Angstroms polysilicon (polysilicon 2) is deposited and doped with phosphorous. Then, a 2500 Angstroms tungsten silicide layer is deposited and a polysilicon 2 mask has three functions: defining the gates of the transistors in the periphery, defining the gates of the access transistors in the array, and defining the word lines of the EPROM cells. Next, the tungsten silicide layer and the polysilicon 2 layer are plasma etched.

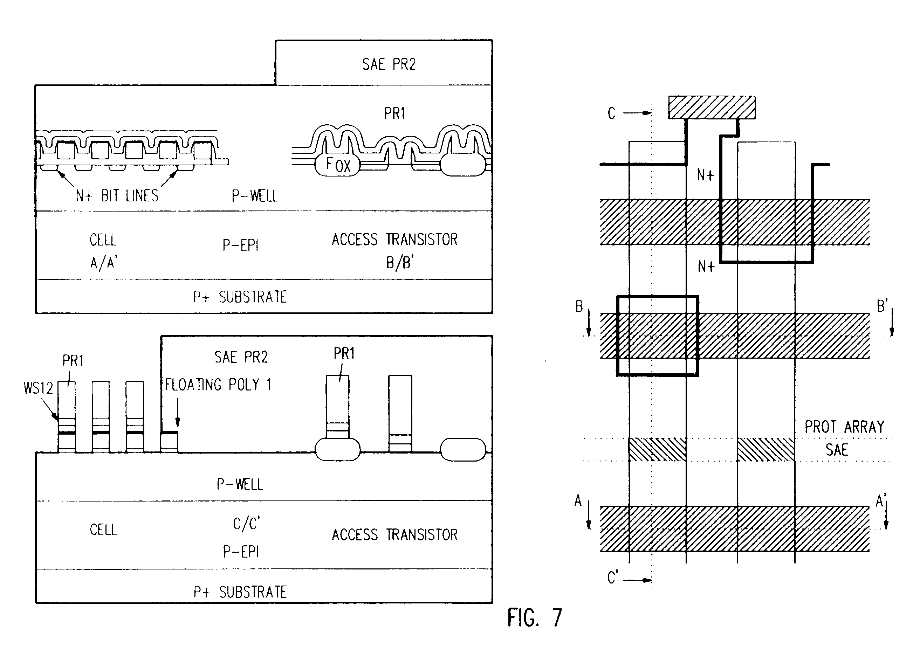

Referring to Figure 7, after this plasma etch, the photoresist is not stripped. A second photoresist is spun on and a new masking step is performed. This new mask is called self-aligned etch (SAE) and has two functions, First, it maintains the integrity of the photoresist of the proceeding polysilicon 2 mask in order to allow self-aligned etch to polysilicon 2 of residual ONO/polysilicon 1 layer between the lines in the EPROM cell array. This etch ends the construction of the EPROM cell. Second, it protects the periphery in the access transistors during the SAE etch.

Particular note is made at this state that, as shown in Figure 6, in Figure 7, the SAE mask is intentionally lower than the protect array mask. This is to avoid digging the silicon over the N+ bit lines and, mainly, between adjacent N+ bit lines. This leads to the formation of polysilicon 1 floating gates at the overlap between the protect array and the SAE masks. Since this floating polysilicon can lead to leakages between adjacent bit lines during the programming of the cells, a special implant mask and boron implant is performed at the beginning of the process in those areas (i.e. at protect array/SAE overlap) in order to increase the threshold voltage of these parasitic floating polysilicon 1 devices and at the same time suppressing the parasitic leakage.

The digging of silicon between adjacent bit lines at the region between the protect array and SAE masks, if they do not overlap intentionally, may be acceptable provided that the quality of the N+ bit line/ P- junction is not degraded in terms of leakage. If there is no effect on junction leakage, then overlap between the SAE and protect array masks and the special implant mask are not required because the parasitic floating gates do not exist.

### SCENARIO 2

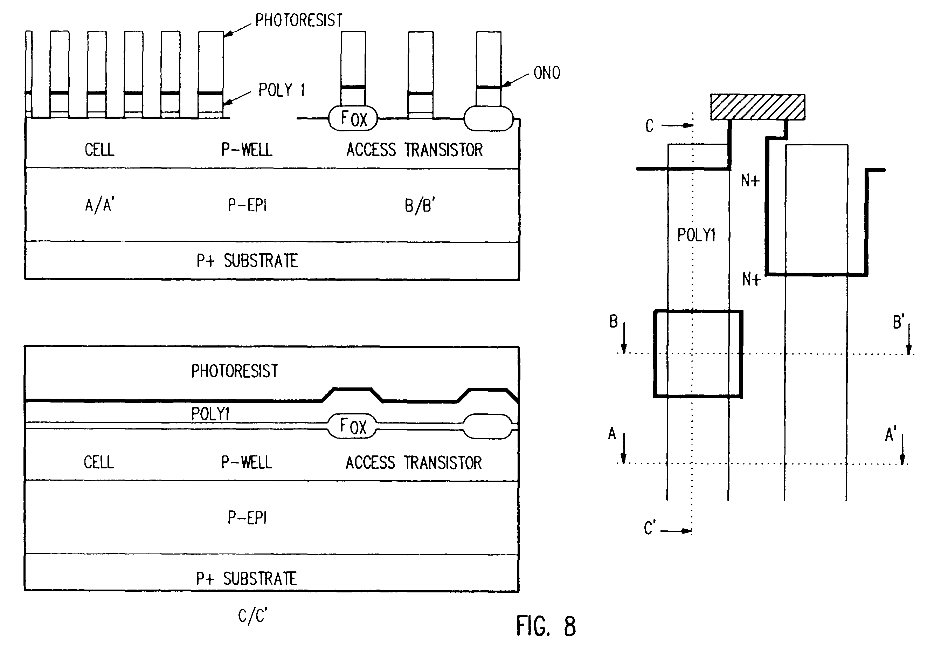

The process flow for Scenario 2 is illustrated in Figures 8-12.

The initial steps of the Scenario 2 flow are the same as in Scenario 1 to formation of the polysilicon 1.

Referring to Figure 8, as in Figure 4, again, only three layers are formed on top of the polysilicon 1: oxide/nitride/oxide (ONO). After growing these three layers, the polysilicon 1 mask defines vertical strips of polysilicon 1 which are plasma etched, leading to parallel vertical lines of ONO/polysilicon 1.

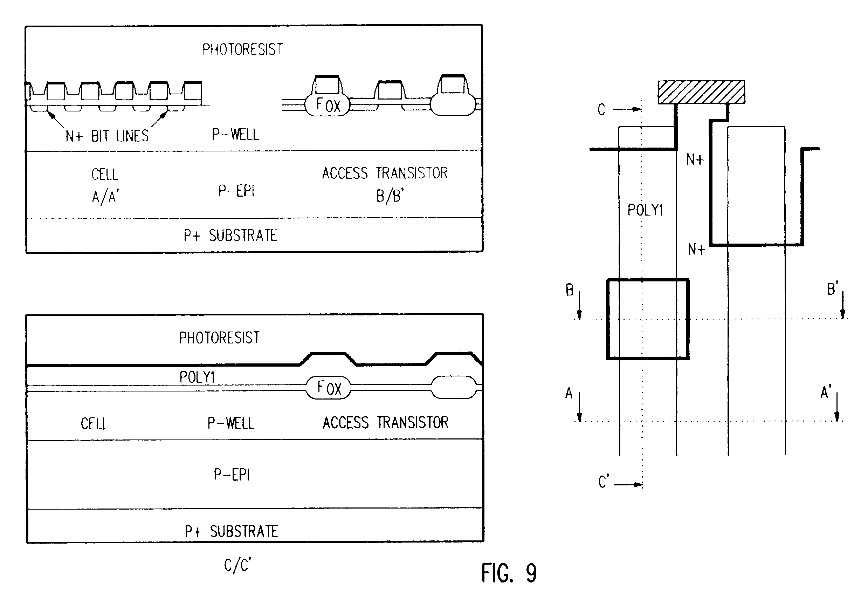

As shown in Figure 9, after stripping the photoresist from the polysilicon 1 mask, an edge oxide is grown between the polysilicon 1 lines and then a self-aligned to polysilicon 1 arsenic implant is performed, defining the N+ bit line. Then, a thin "differential oxide" (500-800 Angstroms) is grown over the N+ bit line areas to give substantial latitude to further ONO and/or polysilicon plasma etch steps.

As will be described in greater detail below, Scenario 2 involves only the SAE etch (compared to Scenario 1, which involve both the Protect Array and SAE etch in areas of the access transistors). For this reason, a thinner differential oxide is permitted in the Scenario 2 flow.

Next, the protect array mask is performed. This mask has the same function as the protect array mask in Scenario 1, except for one point: the regions of the access transistors are now protected. The ONO/polysilicon 1 layers are then plasma etched and the underlying floating gate oxide is etched off in wet chemistry, for example diluted HF. Then the photoresist is stripped.

As shown in Figure 9, after the protect array etch, the parallel vertical lines of polysilicon 1 still remain in the access transistor areas.

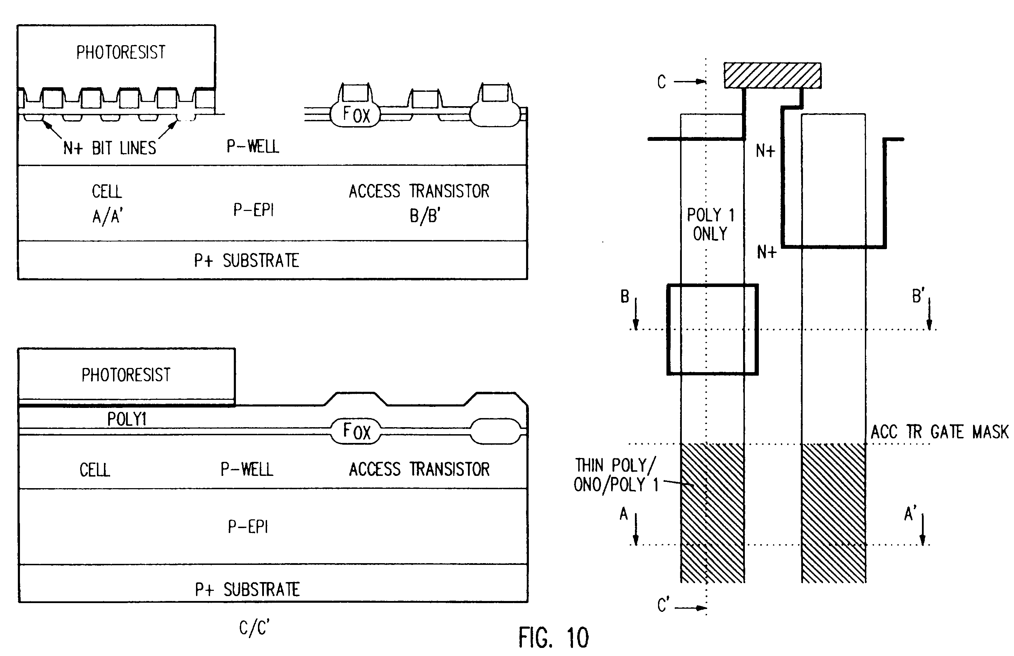

Referring now to Figure 10, next, the gate oxide 2 is grown everywhere in the gate regions out of the array. Then a thin polysilicon layer (200 Angstroms) is deposited. This polysilicon layer is optional; the function of this layer is to avoid spinning on photoresist on the peripheral gate oxide for the further described threshold voltage and access transistor gate masks (photoresist on gate oxide may lead to contamination issues).

Next, the VTP threshold voltage mask is performed and P-channel regions are boron implanted to provide the right threshold voltage. After a photoresist strip, a new masking step is performed: access transistor gate mask. The function of this mask is to open the photoresist only over regions of the access transistors in order to remove by plasma etch the thin poly layer and the underlying ONO.

As shown in Figure 10, the layout presents the different layers at the end: on the upper side of the access transistor gate mask there is no more ONO over polysilicon 1 lines. This allows short circuiting with the polysilicon 1 the further deposited polysilicon 2. On the lower side of the mask, thin polysilicon/ONO/polysilicon 1 vertical lines are still present to further provide the floating gates of the EPROM cells.

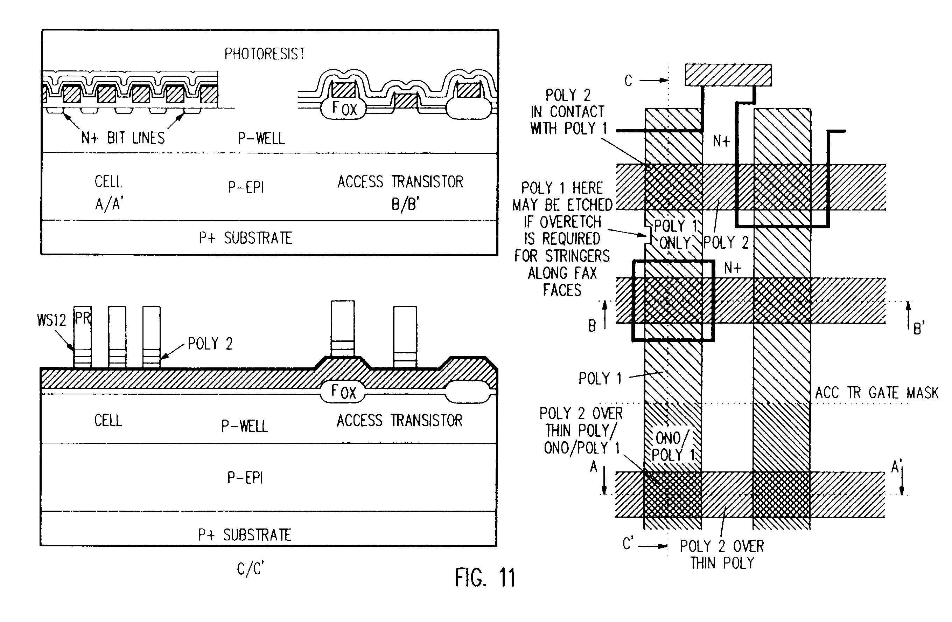

Referring now to Figure 11, in the next step, 2000 Angstroms polysilicon 2 is deposited and doped. Then a 2500 Angstroms tungsten silicide layer is deposited and the polysilicon 2 mask is performed. This mask has three functions: defining the gate of the transistor in the periphery, defining the gate of the access transistor in the array, and defining the word lines of the EPROM cells. Then the silicide/polysilicon 2 layers are plasma etched.

Compared to Scenario 1, the access transistor gate is no longer polysilicon 2, but polysilicon 1, i.e. the gate oxide is floating gate oxide.

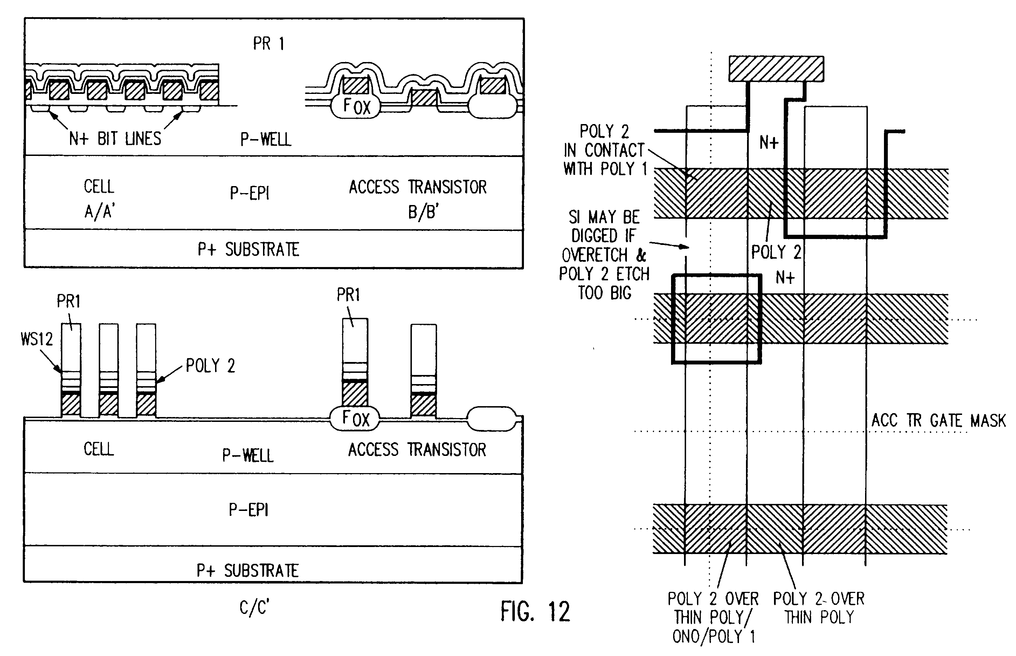

Referring now to Figure 12, after this plasma etch, the photoresist is not stripped. A second photoresist is spun on and a new masking step is performed. This new mask called self-aligned etch (SAE) has two functions. First, it protects the photoresist of the proceeding polysilicon 2 mask in order to allow self-aligned etch to polysilicon 2 of a residual ONO/polysilicon 1 layers between the word lines in the EPROM cell areas. This etch ends the construction of the EPROM cell. Second, it protects the periphery areas during SAE etch.

Compared to Scenario 1, the access transistor areas are not protected by SAE, because ONO/polysilicon 1 has to be removed in these areas. An important issue to note is not to etch the polysilicon 1 at the end of the first silicide/polysilicon 2/thin polysilicon etch. Otherwise, the polysilicon 1 may be etched away in the access transistor areas before the end of etching the polysilicon 1 in the EPROM cell at the SAE etch, leading to some digging of silicon in these areas.

As a general comparison of Scenarios 1 and 2 as described above, Scenario 2 has the following advantages. First, the parasitic polysilicon 1 floating gates crossing the SAE/protect array do not exist. It is noted that the special mask at the beginning of the process in Scenario 1 is also no longer required. Second, this mask is replaced by an access transistor gate mask which allows the contact from polysilicon 2 to polysilicon 1 over the access transistor gate areas. Third, since the protect array etch is not performed over the access transistor areas, the thickness of differential oxide may be relaxed. Even more, this will help at the same time to decrease the N+ bit line lateral diffusion. Fourth, no more lift off is required.

## Claims

1. A method of fabricating a cross-point EPROM array in a silicon substrate of P-type conductivity, the array including a cell array area and a peripheral area, the method comprising:
(a) forming a layer of first insulating material on the silicon substrate;
(b) forming a first layer of polysilicon from which a floating gate is to be fabricated on the layer of insulating material;
(c) forming a layer of second insulating material on the first layer of polysilicon;
(d) forming a first mask to define parallel lines on the second insulating material and underlying first layer of polysilicon;
(e) etching exposed portions of the second insulating material and underlying first layer of polysilicon to define parallel vertical strips of second insulating material and first layers of polysilicon, this etching step being prior to deposit of a second polysilicon layer from which word lines are to be fabricated;
(f) after removing the first mask, forming N+ regions in the silicon substrate between the parallel vertical strips of second insulating material and first layer of polysilicon;
(g) performing a differential oxidation step to form additional oxide on the second insulating material of the vertical strips while simultaneously forming oxide over the N+ regions;
(h) forming a second mask for protecting the cell array area;
(i) removing the second insulating material, and underlying first layer of polysilicon and first insulating material from the peripheral area;
(j) after removing the second mask, forming gate oxide regions in the peripheral area;
(k) forming the second layer of polysilicon from which word lines are to be fabricated over the structure formed in steps (a)-(j) above;
(l) forming a layer of conductive material over the second layer of polysilicon;
(m) forming a third mask on the layer of conductive material to define parallel lines of the second layer of polysilicon that run perpendicular to the strips of the first polysilicon layer ;
(n) etching the conductive material and the underlying second layer of polysilicon to define polysilicon word lines running perpendicular to the strips of the first layer of polysilicon but separated therefrom by the second insulating material;
(o) forming a self aligned etch mask over the third mask in the peripheral area; and
(p) utilizing the polysilicon word lines in a stacked etch step to define the floating gates in the first layer of polysilicon at the cross-point EPROM cells of the array.

2. A method as in claim 1 wherein the first insulating material is silicon dioxide.

3. A method as in claim 2 wherein the second insulating material is a composite layer of oxide-nitride-oxide.

4. A method as in claim 3 wherein the conductive material is tungsten silicide.

## Patentansprüche

1. Verfahren zum Herstellen einer Kreuzpunkt-EPROM-Anordnung in einem Siliziumsubstrat mit P-Leitfähigkeit, wobei die Anordnung einen Zellenfeldbereich und einen Peripheriebereich aufweist, und wobei das Verfahren aufweist:
a) Ausbilden einer Schicht aus ersten Isoliermaterial auf dem Siliziumsubstrat,
b) Ausbilden einer ersten Schicht aus Polysilizium, aus dem ein floatendes Gate herzustellen ist, auf der Schicht aus Isoliermaterial,
c) Ausbilden einer Schicht aus zweitem Isoliermaterial auf der ersten Schicht aus Polysilizium,
d) Ausbilden einer ersten Maske, um parallele Leitungen auf dem zweiten Isoliermaterial und der unterliegenden ersten Schicht aus Polysilizium zu definieren,
e) Ätzen freiliegender Teile des zweiten Isoliermaterials und der unterliegenden ersten Schicht aus Polysilizium um parallele vertikale Streifen aus zweitem Isoliermaterial und ersten Schichten aus Polysilizium zu definieren, wobei dieser Ätzschritt vor dem Abscheiden einer zweiten Polysiliziumschicht erfolgt, aus der Wortleitungen herzustellen sind,
f) nach der Entfernung der ersten Maske das Ausbilden von N+-Bereichen in dem Siliziumsubstrat zwischen den parallelen vertikalen Streifen des zweiten Isoliermaterials und der ersten Schicht des Polysiliziums,
g) Durchführen eines Differenzoxidationsschrittes zur Ausbildung von zusätzlichem Oxid auf dem zweiten Isoliermaterial der vertikalen Streifen, während gleichzeitig Oxid über den N+-Bereichen gebildet wird,
h) Ausbilden einer zweiten Maske zum Schutz des Zellfeldbereichs,
i) Entfernen des zweiten Isoliermaterials und der unterliegenden ersten Schicht aus Polysilizium und des ersten Isoliermaterials aus dem Peripheriebereich,
j) nach dem Entfernen der zweiten Maske die Ausbildung von Gateoxidbereichen in dem Peripheriebereich,
k) Ausbilden der zweiten Schicht aus Polysilizium, aus der Wortleitungen zu fertigen sind, über der in den obengenannten Schritten (a)-(j) gebildeten Struktur,
l) Ausbilden einer Schicht aus leitendem Material über der zweiten Schicht aus Polysilizium,
m) Ausbilden einer dritten Maske auf der Schicht aus leitfähigem Material, um parallele Leitungen der zweiten Schicht aus Polysilizium zu definieren, die rechtwinklig zu den Streifen der ersten Polysiliziumschicht verlaufen,
n) Ätzen des leitfähigen Materials und der unterliegenden zweiten Schicht aus Polysilizium, um Polysiliziumwortleitungen zu definieren, die rechtwinklig zu den Streifen der ersten Schicht aus Polysilizium verlaufen, von diesen aber durch das zweite Isoliermaterial getrennt sind,
o) Ausbilden einer selbstausrichtenden Ätzmaske über der dritten Maske im Peripheriebereich und
p) Einsatz der Polysiliziumwortleitungen in einem Stapelätzschritt zum Definieren der floatenden Gates in der ersten Schicht des Polysiliziums an Kreuzpunkt-EPROM-Zellen der Anordnung.

2. Verfahren nach Anspruch 1,
wobei das erste Isoliermaterial Siliziumdioxid ist.

3. Verfahren nach Anspruch 2,
wobei das zweite Isoliermaterial eine Verbundschicht aus Oxid-Nitrid-Oxid ist.

4. Verfahren nach Anspruch 3,
wobei das leitfähige Material Wolframsilizid ist.

## Revendications

1. Procédé de fabrication d'une matrice d'EPROM (mémoire morte programmable et effaçable) à points de connexion dans un substrat de silicium de conductivité de type P, la matrice incluant une zone de matrice de cellules et une zone périphérique, le procédé comprenant :
(a) la formation d'une couche d'une première matière isolante sur le substrat de silicium ;
(b) la formation d'une première couche de silicium polycristallin à partir de laquelle une grille flottante doit être fabriquée sur la couche de matière isolante ;
(c) la formation d'une couche d'une seconde matière isolante sur la première couche de silicium polycristallin;
(d) la formation d'un premier masque pour définir des lignes parallèles sur la seconde matière isolante et sous-jacente à la première couche de silicium polycristallin ;
(e) l'attaque des parties exposées de la seconde matière isolante et sous-jacente à la première couche de silicium polycristallin pour définir des bandes verticales parallèles de la couche de seconde matière isolante et de la première couche de silicium polycristallin, cette étape d'attaque étant antérieure au dépôt d'une seconde couche de silicium polycristallin à partir de laquelle des lignes de mot doivent être fabriquées ;
(f) après élimination du premier masque, la formation de régions de type N+ dans le substrat de silicium entre les bandes parallèles de seconde matière isolante et la première couche de silicium polycristallin ;
(g) l'exécution d'une étape d'oxydation différentielle pour former de l'oxyde supplémentaire sur la seconde matière isolante des bandes verticales tout en formant simultanément de l'oxyde sur les régions de type N+ ;
(h) la formation d'un second masque destiné à protéger la zone de matrice de cellules ;
(i) l'élimination de la seconde matière isolante, et de la première couche sous-jacente de silicium polycristallin et de la première matière isolante de la zone périphérique ;
(j) après élimination du second masque, la formation de régions d'oxyde de grille dans la zone périphérique ;
(k) la formation, sur la structure formée dans les étapes (a) à (j) ci-dessus, de la seconde couche de silicium polycristallin à partir de laquelle des lignes de mot doivent être fabriquées ;
(l) la formation d'une couche de matière conductrice sur la seconde couche de silicium polycristallin ;
(m) la formation d'un troisième masque sur la couche de matière conductrice pour définir des lignes parallèles de la seconde couche de silicium polycristallin qui courent perpendiculairement aux bandes de la première couche de silicium polycristallin ;
(n) l'attaque de la matière conductrice et de la seconde couche sous-jacente de silicium polycristallin pour définir des lignes de mot en silicium polycristallin, courant perpendiculairement aux bandes de la première couche de silicium polycristallin, mais séparées de celles-ci par la seconde matière isolante ;
(o) la formation, sur le troisième masque, dans la zone périphérique, d'un masque d'attaque auto-aligné ; et
(p) l'utilisation des lignes de mot en silicium polycristallin dans une étape d'attaque empilée pour définir les grilles flottantes dans la première couche de silicium polycristallin au niveau des cellules d'EPROM à points de connexion de la matrice.

2. Procédé selon la revendication 1, dans lequel la première matière isolante est du dioxyde de silicium.

3. Procédé selon la revendication 2, dans lequel la seconde matière isolante est une couche composite d'oxyde - nitrure - oxyde.

4. Procédé selon la revendication 3, dans lequel la matière conductrice est du siliciure de tungstène.
